# FASCICULE DE BREVET EUROPEEN

(11) **EP 3 695 966 B1**
(45) Date de publication et mention de la délivrance du brevet: **05.01.2022**
(21) Numéro de dépôt: 20156984.5
(22) Date de dépôt: 12.02.2020
(51) Int. Cl.: B32B 33/00, B32B 37/12, B42D 25/305, H05K 1/14, G06K 19/077, H05K 3/32

(54) **CARTE ÉLECTRONIQUE COMPORTANT UNE SOUS-CAVITÉ DE RÉCEPTION D'ADHÉSIF POUR L'ENCARTAGE D'UN MODULE ET PROCÉDÉ DE RÉALISATION D'UNE TELLE CARTE ÉLECTRONIQUE**
ELEKTRONISCHE KARTE, DIE EINE UNTERAUSSPARUNG ZUR AUFNAHME VON KLEBER ZUM EINSETZEN EINES MODULS UMFASST, UND HERSTELLUNGSVERFAHREN EINER SOLCHEN ELEKTRONISCHEN KARTE
ELECTRONIC CARD COMPRISING AN ADHESIVE RECEIVING SUB-CAVITY FOR INSERTING A MODULE AND METHOD FOR MANUFACTURING SUCH AN ELECTRONIC CARD

(30) Priorité: 18.02.2019 FR 1901596
(43) Date de publication de la demande: 19.08.2020
(73) Titulaire: IDEMIA France, 92400 Courbevoie (FR)
(72) Inventeur: HUET, Mickaël, 92400 Courbevoie (FR); BOSQUET, Olivier, 92400 Courbevoie (FR)
(74) Mandataire: Santarelli

(56) Documents cités:
- WO-A1-2016/051092
- GB-A- 2 548 638
- GB-A- 2 548 639

## Description

La présente invention concerne une carte électronique comportant un corps et un module encarté dans le corps. Elle concerne aussi un procédé de réalisation d'une telle carte électronique.

Une carte électronique comporte typiquement un corps et au moins un composant électronique intégré dans le corps, soit au sein du corps, soit dans une cavité formée dans le corps et débouchant à une surface du corps. Généralement, plusieurs composants électroniques sont présents.

Un composant électronique placé dans une cavité du corps et débouchant à une surface du corps est par exemple un module encarté.

Une carte électronique telle que considérée est par exemple une carte dite « complexe », qui comporte un circuit imprimé sur un support flexible, dit FPC (pour « flexible printed circuit »). Autrement dit, un FPC comporte typiquement un support relativement souple et flexible et un circuit électronique (i.e. principalement des pistes, généralement en cuivre) imprimé sur le support.

Ce support est par exemple réalisé en un matériau polymère, par exemple en polyimide, par exemple, en Kapton^{®} ou PEN (polyethylene Naphtalate) qui résiste à des hautes températures (typiquement jusqu'à 250°).

De plus, dans certaines cartes complexes, certains éléments de sécurité, comme par exemple une puce, sont localisés directement sur le FPC, et non plus dans le module comme dans des architectures plus traditionnelles.

Afin d'établir une connexion entre le module encarté et la puce, qui est alors contenue dans le corps à distance de la cavité, le circuit électronique comporte au moins une plaque de contact.

Une « plaque de contact » désigne ici un élément ayant une surface configurée pour établir une connexion électrique avec un autre élément, mais d'épaisseur négligeable. Une telle plaque de contact est généralement incrustée dans un support correspondant, ou posée sur une surface du support puis laminée avec ce support de sorte à ne pas former de surépaisseur, ou au pire une surépaisseur d'épaisseur négligeable, par rapport à cette surface.

La plaque de contact est par exemple une extrémité d'une piste conductrice du circuit imprimé du FPC.

Pour établir la connexion électrique avec le module ultérieurement encarté, une goutte de pâte de soudure ou pâte à braser, c'est-à-dire de la pâte dans un état liquide ou visqueux, est déposée sur la plaque de contact du FPC. Ensuite la goutte durcit, formant ainsi, par définition, une bosse de connexion.

La bosse de connexion est donc ici configurée pour être positionnée au fond de la cavité lorsque celle-ci est formée dans le corps.

L'ensemble ainsi formé, i.e. comportant le FPC, la puce et la bosse de connexion, est optionnellement disposé dans une ouverture d'une couche intermédiaire, puis l'ensemble est noyé dans une résine, puis interposé entre deux autres couches avec lesquelles il est laminé, ce qui contribue à former au moins une partie du corps de la carte.

La cavité est ensuite formée, souvent par usinage (par exemple par fraisage) à partir d'une surface supérieure du corps de carte. La cavité présente alors généralement une seule profondeur.

L'usinage traverse ainsi une couche supérieure du corps de carte et une partie d'une épaisseur de la résine dans laquelle est noyé l'ensemble précité.

A cette occasion, la bosse de connexion est aussi usinée sur une partie de sa hauteur, ce qui forme alors une surface de contact (généralement en forme de disque) avec laquelle la connexion électrique du module peut ensuite être établie lorsqu'il est encarté.

Pour établir la connexion électrique entre le module et la surface de contact de la bosse de connexion située au fond de la cavité, une possibilité est d'appliquer un adhésif électriquement conducteur, par exemple un adhésif anisotrope (souvent désigné « ACF » pour « anisotropic conductive film »).

Le module est ensuite placé dans la cavité et une pression y est appliquée. En outre, cette pression est souvent appliquée à chaud.

Or, l'application de la pression a pour effet de chasser l'adhésif, notamment dans des zones de la cavité où il y a moins de pression.

En conséquence, la connexion électrique peut ne pas s'établir correctement.

Un exemple de carte électronique et son procédé de fabrication selon l'art antérieur sont décrits dans le document WO 2016/051092 A1.

L'objet de la présente demande vise ainsi à résoudre au moins en partie les inconvénients précités, menant en outre à d'autres avantages.

A cet effet, est proposé selon un premier aspect, une carte électronique comportant :
- un corps de carte, comportant au moins un ensemble comportant au moins un support flexible et un circuit électronique imprimé sur le support flexible, dit FPC, le FPC comportant au moins une plaque de contact en surface du support, et au moins une bosse de connexion fixée sur la plaque de contact du FPC, l'ensemble comportant en outre au moins une puce, connectée au circuit électronique du FPC, à distance de la plaque de contact, et l'ensemble étant noyé dans une résine ;
- une cavité formée dans le corps de carte, la cavité ayant un fond dans lequel apparait une surface de contact de la bosse de connexion ;
- un module, encarté dans la cavité, comportant une face intérieure comportant au moins une plage de contact électrique ;
la carte électronique étant **caractérisée en ce** qu'une couche d'adhésif électriquement conducteur recouvre la face intérieure comportant l'au moins une plage de contact électrique du module pour connecter électriquement la plage de contact électrique du module à la surface de contact de la bosse de connexion située au fond de la cavité **et en ce** que la carte électronique comporte en outre une sous-cavité, formée dans le fond de la cavité, à distance d'une périphérie de la cavité, et remplie au moins en partie par de l'adhésif électriquement conducteur, la surface de contact de la bosse de connexion étant au moins en partie en dehors de la sous-cavité.

L'invention propose ainsi de creuser une sous-cavité, plus profonde que la cavité, dans le fond de la cavité, c'est-à-dire de réaliser un déversoir, dans lequel l'adhésif peut se déverser lorsque le module est encarté et qu'une pression lui est appliquée alors que l'adhésif est préalablement appliqué sur sa face dite « intérieure ».

La sous-cavité est donc configurée pour recevoir de l'adhésif lors de l'encartage d'un module, et éventuellement servir de réservoir d'adhésif.

La présence d'une sous-cavité permet ainsi à l'adhésif de s'y écouler et l'adhésif est ainsi pressé correctement.

Avec une cavité dont le fond a une profondeur uniforme, l'adhésif est repoussé loin du centre de la cavité et il peut rapidement y avoir une perte de connexion. En outre, lorsqu'il s'agit d'un ACF, les particules ne sont alors pas correctement pressées.

Lorsque l'adhésif est chauffé et pressé, il diminue en épaisseur sur la zone de pressage. La matière est chassée vers des zones moins pressées. Il faut donc prévoir des zones « tampon », ici la sous-cavité, où la matière peut se déplacer.

Autrement dit, la présente invention prévoit au moins une zone de stockage pour l'adhésif rejeté lors d'un pressage à chaud.

Ainsi, afin de connecter électriquement la plage de contact électrique du module à la surface de contact de la bosse de connexion située au fond de la cavité, la couche d'adhésif électriquement conducteur recouvre la face intérieure du module, et plus particulièrement au moins la plage de contact électrique de la face intérieure du module.

En outre, l'adhésif s'étale alors sur au moins 75% d'une surface de la face intérieure du module, voire 80 %, voire 90 %, et de préférence du mieux possible sur l'intégralité de la surface de la face intérieure du module.

Dans un exemple de réalisation intéressant, la sous-cavité présente une profondeur d'au moins 20 µm, par exemple de 50 µm +/- 15 µm, par rapport au fond de la cavité.

De préférence, la sous-cavité est centrée par rapport à la cavité.

Par exemple, la sous-cavité est configurée pour entourer au moins la bosse de connexion.

Selon un exemple, la sous-cavité a une forme d'anneau.

Selon un autre exemple, la sous-cavité comporte au moins une alvéole.

Par exemple, la sous-cavité comporte plusieurs alvéoles disposées entre des bosses de connexion.

Dans un exemple de réalisation privilégié, une surface apparente de la sous-cavité représente entre 20% et 50% d'une surface apparente de la cavité, voire entre 20% et 35%.

Dans un exemple de réalisation intéressant, la couche d'adhésif électriquement conducteur présente une épaisseur comprise entre 150 µm et 250 µm entre la face intérieure du module et le fond de la cavité.

Le corps de la carte électronique est par exemple conforme aux normes en vigueur, notamment ISO 7810 et ISO 7816.

Selon la norme ISO 7816, le corps de carte peut avoir plusieurs formats, également normalisés. Quatre formats standardisés, connus sous les désignations suivantes (voir notamment la norme ETSI TS 102 221 et la norme ISO 7816), sont principalement utilisés :
- ID-1 ayant une longueur de 85,6 mm, une largeur de 54 mm, et une épaisseur de 0,76 mm ; ce format est parfois désigné par 1 FF (pour « premier facteur de forme ») ;
- ID-000 (aussi appelée Plug-in UICC, ou carte SIM GSM) ayant une longueur de 25 mm, une largeur de 15 mm, et la même épaisseur de 0,76 mm ; ce format est parfois désigné par 2FF (pour « deuxième facteur de forme ») ;
- Mini-UICC (parfois aussi appelée carte SIM), avec une longueur de 15 mm, une largeur de 12 mm et la même épaisseur de 0,76 mm ; ce format est parfois désigné par 3FF (pour « troisième facteur de forme ») ;
- Un quatrième format, encore plus petit, appelé nano-SIM ou 4FF (pour « quatrième facteur de forme »), dont le corps de carte mesure 12,3 mm x 8,8 mm x 0,67 mm.

Les notions de longueur et de largeur sont ici définies par référence à l'orientation du microcircuit.

Les tolérances de l'ensemble des cartes décrites ici sont de l'ordre de 0,1 mm.

L'ensemble comportant le FPC et la puce est par exemple noyé dans le corps de la carte électronique.

L'ensemble est par exemple noyé dans une résine, par exemple une résine polyuréthane (PU).

En particulier, l'ensemble est possiblement disposé dans une ouverture d'une couche intermédiaire, et l'ensemble et la couche intermédiaire sont noyés dans une résine.

En outre, l'ensemble noyé dans une résine est par exemple laminé entre deux couches formant au moins en partie le corps de carte.

Les deux couches sont alors disposées de part et d'autre de la résine enrobant l'ensemble.

Au moins l'une des deux couches est par exemple en PVC ou PET ou polycarbonate.

Les couches peuvent être constituées d'un même matériau ou de différents matériaux selon la carte à réaliser.

Optionnellement, le corps peut aussi comporter au moins une couche, couramment appelée « overlay », par exemple en PVC, disposée sur au moins l'une des couches laminées. En particulier, la carte peut comporter deux couches « overlay » disposées de part et d'autre de l'ensemble laminé entre deux couches.

En outre, la carte comporte ici une cavité, formée dans le corps de la carte.

En particulier, il s'agit alors d'une cavité débouchant à une surface du corps de carte, c'est-à-dire une cavité ouverte et borgne.

La surface de contact de la bosse de connexion est alors apparente dans la cavité.

Autrement dit, la surface de contact forme au moins une partie du fond de la cavité.

Dans un exemple de réalisation, la cavité présente une surface apparente de dimensions environ égales à 8,5 mm * 11 mm.

La norme ISO 7816 précise aussi par exemple la configuration d'un module au sein d'un corps de carte.

Selon la norme ISO 7816, un tel module peut comporter un film porteur, aussi appelé, selon les cas, substrat isolant, ou vignette, ou plaquette flexible, etc.

Le film comporte une face, dite face extérieure, car elle est destinée à être accessible de l'extérieur de la carte qui sera équipée de ce module, et une face, dite face intérieure, opposée à la face extérieure, et destinée à être orientée vers l'intérieur de la cavité ménagée dans le corps de carte pour recevoir le module.

La face extérieure du module comporte par exemple des zones de contact selon une configuration bien définie.

La face intérieure porte par exemple des plages de contact, plus particulièrement dans ce cas des points de contact, connectés électriquement à au moins une partie des zones de contact de la face extérieure.

La configuration des zones de contact de la face extérieure est habituellement conforme à la norme ISO 7816 qui prévoit la présence de huit zones de contact réparties en deux séries parallèles de quatre zones de contact ayant des fonctions bien définies ; ces zones de contact sont habituellement désignées par les références C1 à C8 :
- la zone de contact C1 étant destinée à recevoir une tension d'alimentation notée Vcc (ou Vdd), encore appelé « l'alimentation positive » ;
- la zone de contact C2 étant destinée à recevoir un signal d'initialisation ou remise à zéro de la puce, noté RST ;
- la zone de contact C3 étant destinée à recevoir un signal d'horloge noté CLK ;
- la zone de contact C4 étant destinée à recevoir un signal dépendant de l'application visée ;
- la zone de contact C5 étant destinée à recevoir une tension de masse notée GND (ou Vss), encore appelée la « terre » ;
- la zone de contact C6 étant destinée à recevoir une tension de programmation de carte à mémoire notée VPP pour un protocole de communication SWP (« Single Wire Protocole ») ;
- la zone de contact C7, encore appelé I/O, étant destinée à recevoir un signal d'entrée/sortie d'échange de données avec la puce ; et
- la zone de contact C8 étant destinée à coopérer avec la zone C4 en fonction de l'application visée.

Les zones de contact C4 et C8 n'ont pas toujours été utilisées dans le passé, mais le sont de plus en plus, notamment pour des communications USB, ou pour des communications SPI.

Une version révisée de la norme ISO 7816 (version 7816-2&10&12) précise que la plage C4 peut avoir une fonction de reset, d'écriture ou de lecture, ou de borne D+ pour une fonction USB, tandis que la plage C8 peut avoir une fonction de borne D- pour une fonction USB.

La norme ISO 7816-2 fixe en outre les positions réciproques des diverses zones de contact, ainsi que les dimensions minimales de ces zones de contact, à savoir 2 mm de large et 1,7 mm de haut (par convention, les plages sont disposées en séries verticales, près des petits côtés du film porteur (qui a une forme globalement rectangulaire avec des coins arrondis).

Dans un autre exemple de réalisation particulier, le module comporte un capteur, ou un afficheur, ou encore une LED.

Ainsi, dans un mode de réalisation privilégié ici, la face intérieure du module peut comporter au moins une plage de contact électrique, et celle-ci est connectée avec un capteur, un afficheur, ou encore une LED, de la face extérieure du module.

La connexion est par exemple établie par au moins un via métallisé, traversant le film porteur.

Un capteur d'un tel module comporte par exemple un capteur biométrique, comme un capteur d'empreinte digitale.

Un afficheur est par exemple configuré pour afficher un code de carte à usage unique, par exemple trois digits qui se rafraichissent à intervalles de temps établis.

Par exemple, la carte électronique a plusieurs modes de fonctionnement et comporte un actionneur, par exemple un bouton, configuré pour sélectionner un des modes de fonctionnement de la carte.

Et par exemple, la carte comporte autant de LED qu'elle a de modes de fonctionnement.

Ainsi, une LED permet par exemple d'identifier le mode de fonctionnement sélectionné ou actif.

Est également proposé, selon encore un autre aspect, un procédé de réalisation d'une carte électronique, telle que décrite précédemment, comportant les étapes suivantes :
- Réalisation d'un corps de carte comportant un FPC et une puce connectée à un circuit électronique imprimé du FPC et disposée à distance d'une plaque de contact du FPC sur laquelle est fixée une bosse de connexion, le FPC la puce et la bosse de connexion étant noyé dans une résine ;
- Formation d'une cavité de profondeur constante comportant une étape d'usinage de la bosse de connexion formant une surface de contact de la bosse de connexion ;
- Formation d'une sous-cavité, au fond de la cavité, à distance d'une périphérie de la cavité, la surface de contact de la bosse de connexion étant au moins en partie en dehors de la sous-cavité ;
- Fourniture d'un module présentant une face intérieure comportant au moins une plage de contact électrique ;
- Application d'un adhésif électriquement conducteur sur la face intérieure comportant l'au moins une plage de contact électrique du module ;
- Mise en place du module dans la cavité ; et
- Application d'une pression sur au moins une partie d'une face extérieure du module avec un presseur.

Ainsi, l'adhésif électriquement conducteur est appliqué sur la face intérieure du module en recouvrant au moins la plage de contact électrique afin de connecter électriquement la plage de contact électrique du module à la surface de contact de la bosse de connexion située au fond de la cavité.

Dans un exemple de mise en œuvre, la pression est appliquée sur une périphérie de la face extérieure du module.

Dans un exemple de mise en œuvre, la pression appliquée sur le module est homogène sur la face extérieure du module et est appliquée avec un presseur plein.

Selon un exemple de réalisation, l'étape de formation de la sous-cavité comporte une étape d'usinage à une profondeur de 50 µm à partir du fond de la cavité.

L'invention, selon un exemple de réalisation, sera bien comprise et ses avantages apparaitront mieux à la lecture de la description détaillée qui suit, donnée à titre indicatif et nullement limitatif, en référence aux dessins annexés dans lesquels :
La figure 1 représente un exemple de réalisation de bosses de connexion sur un FPC agencées dans un fond d'une cavité ;
La figure 2 illustre schématiquement une cavité comportant une sous-cavité selon un exemple de réalisation de l'invention ;
La figure 3 illustre schématiquement une cavité comportant une sous-cavité selon un autre exemple de réalisation de l'invention ;
La figure 4 illustre schématiquement une étape d'encartage d'un module selon un exemple de mise en œuvre de l'invention vu en coupe ; et
La figure 5 représente schématiquement, en coupe, une carte électronique selon un exemple de réalisation conforme à la figure 4.

Les éléments identiques représentés sur les figures précitées sont identifiés par des références numériques identiques.

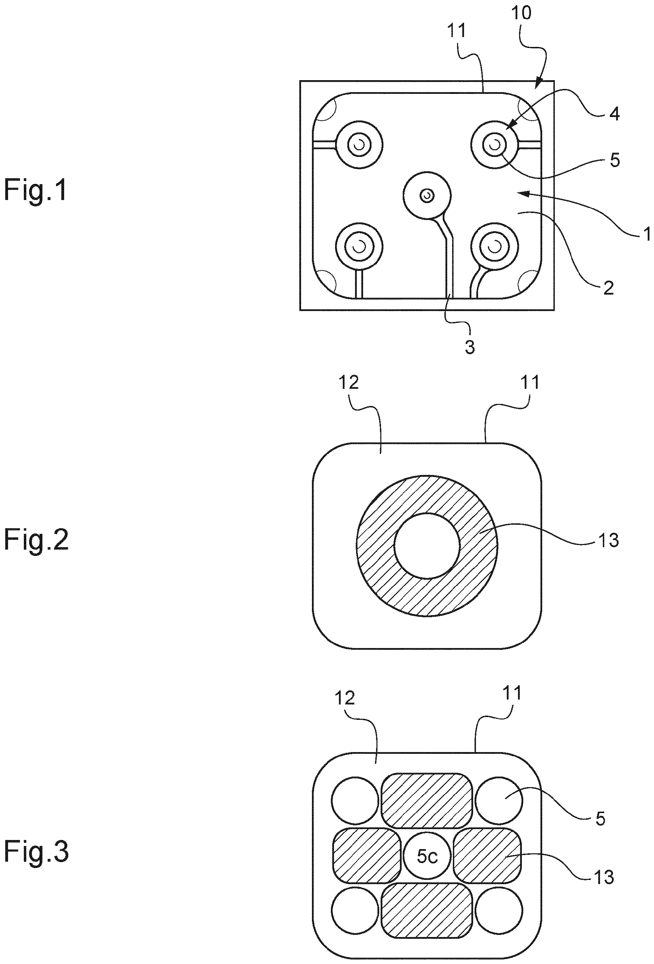

La figure 1 représente schématiquement un FPC 1 (pour « flexible printed circuit »), c'est-à-dire un circuit imprimé sur un support flexible dont une partie est visible au fond d'une cavité 11 d'un corps 10 de carte électronique.

La cavité 11 a typiquement une forme rectangulaire, éventuellement avec des coins arrondis.

Le FPC 1 comporte un support 2, relativement souple et flexible, et un circuit électronique 3 (i.e. principalement des pistes, généralement en cuivre) imprimé sur le support 2.

Le support 2 du FPC peut être considéré comme une feuille. Il présente une certaine souplesse.

Le support 2 est par exemple réalisé en un matériau polymère, par exemple en polyimide, ou en tout autre matériau ayant de préférence une élasticité comparable, par exemple en Kapton^{®}.

Le support 2 du FPC 1 présente, par définition, une largeur et une hauteur, inférieures aux dimensions correspondantes du corps de carte auquel il est destiné, et une épaisseur, très inférieure à l'épaisseur de ce corps de carte. La largeur et la hauteur du FPC permettent de définir un contour du support du FPC.

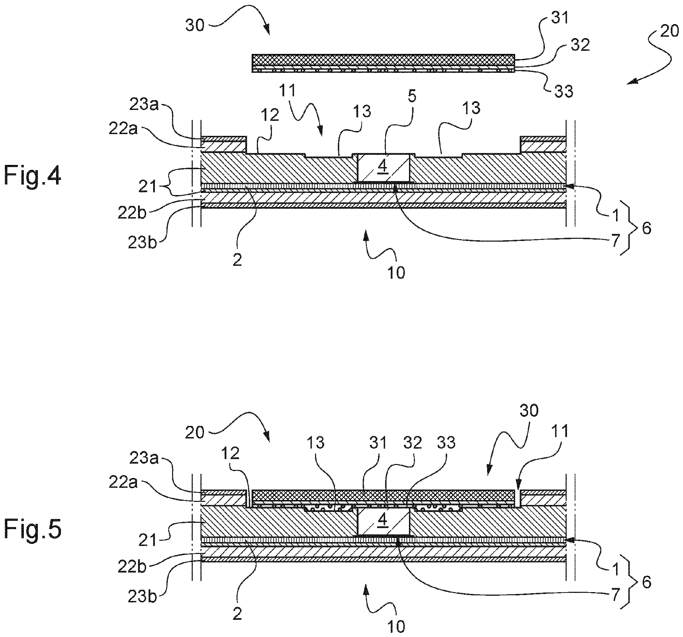

Pour établir un contact électrique avec un composant électronique, par exemple un module, le circuit électronique 3 comprend généralement au moins une plaque de contact (référence 7 sur les figures 4 et 5), généralement plusieurs.

Pour certaines cartes électroniques, un autre composant électronique, par exemple une puce (non représentée) est fixée sur le FPC et connectée au circuit électronique 3 du FPC, à distance de la plaque de contact 7 à laquelle le module est ensuite connecté.

Afin d'établir une connexion électrique entre le circuit électronique 3 et le module (initialement indépendant du FPC), une goutte de pâte de soudure est déposée sur une plaque de contact 7 du circuit électronique 3.

La goutte durcit, et forme alors par définition une bosse de connexion 4. Cette bosse présente dans la plupart des cas une forme conique.

Selon un autre exemple de réalisation, la bosse de connexion peut comporter un plot préformé.

Le FPC, éventuellement avec la puce, et la bosse de connexion 4 forment ainsi un ensemble qui est noyé dans une résine puis laminé entre deux couches disposées de part et d'autre de l'ensemble afin de former un corps de la carte électronique.

Le corps 10 de carte électronique comporte en outre la cavité 11, laquelle est souvent réalisée par usinage, en particulier par fraisage, à partir d'une couche supérieure du corps 10.

Lors de l'usinage du corps 10 pour former la cavité 11, une partie de la résine ainsi qu'une partie de la hauteur de chaque bosse de connexion 4 est usinée, ce qui permet de réaliser une surface de contact 5 pour chaque bosse, à laquelle le module est ensuite relié pour établir une connexion électrique avec le circuit électronique 3.

La cavité 11 présente alors initialement un fond de profondeur uniforme par rapport à une surface supérieure du corps 10.

En conséquence, lorsqu'une couche d'adhésif est appliquée sur une face intérieure d'un module encarté dans la cavité 11 et que le module est pressé dans la cavité 11, souvent à chaud, il se produit un écoulement de l'adhésif loin du centre de la cavité 11, ce qui peut engendrer des pertes de connexion entre le module et les bosses de connexion 4.

Selon l'invention, il est alors proposé de former une sous-cavité 13 dans le fond 12 de la cavité 11, comme l'illustrent schématiquement les figures 2 et 3.

La sous-cavité 13 présente une profondeur supérieure à celle de la cavité 11 par rapport à une surface supérieure du corps.

La sous-cavité 13 est formée à distance d'une périphérie de la cavité 11, et est de préférence centrée par rapport à la cavité 11.

Dans l'exemple de réalisation de la figure 2, la sous-cavité 13 présente une forme d'anneau.

En d'autres termes, la sous-cavité 13 est alors délimitée par deux cercles concentriques, ici centrés par rapport à la cavité 11.

En outre, la sous-cavité 13 est configurée pour entourer au moins une bosse de connexion 4, en l'occurrence ici, il s'agit de la bosse centrale selon l'exemple schématisé figure 1.

Dans cet exemple de réalisation, la sous-cavité 13 représente environ 23,7% de la surface apparente de la cavité 11.

La figure 3 présente un autre exemple de réalisation de la sous-cavité 13.

Dans cet exemple, la sous-cavité 13 est composée de plusieurs alvéoles, ici quatre alvéoles, formées entre les surfaces de connexion 5.

Ainsi, comme dans l'exemple de la figure 2, les alvéoles entourent au moins une bosse de connexion, ici la bosse de connexion centrale, schématisée sur cette figure par sa surface de contact 5c.

En outre, ici, chaque alvéole présente une forme rectangulaire avec des coins arrondis. Chaque alvéole pourrait toutefois avoir une forme circulaire ou oblongue, ou autre.

Dans cet exemple de réalisation, la sous-cavité 13 représente alors environ 32% de la surface apparente de la cavité 11.

Ainsi, dans les exemples de réalisation des figures 2 et 3, il apparait que la cavité 11 présente en son centre une profondeur égale à celle à sa périphérie.

Ceci favorise ainsi un meilleur collage du module dans la cavité.

Le fond 12 de la cavité 11 présente alors une surface configurée pour être collée avec le module comportant au moins la zone périphérique du fond de la cavité et une zone centrale du fond de la cavité.

Les figures 4 et 5 illustrent, selon une vue en coupe, un exemple de réalisation d'une carte électronique 20 selon l'invention.

Il s'agit par exemple d'une carte électronique conforme aux normes en vigueur, notamment ISO 7810 et ISO 7816, comme décrit précédemment.

La carte électronique 20 comporte un corps 10 et un module 30.

Le corps 10 comporte ici un ensemble 6 comportant un FPC 1, par exemple tel que schématisé figure 1 et décrit ci-dessus.

Pour établir la connexion électrique avec le module 30, le circuit électronique 3 du FPC 1 comprend au moins une plaque de contact 7 en surface du support 2 sur au moins une partie de laquelle une bosse de connexion 4 est formée, de préférence centrée par rapport à celle-ci, et y est fixé.

L'ensemble 6 comporte en outre possiblement une puce, non représentée ici, fixée sur le support 2 du FPC 1 et reliée à au moins l'une des plaques de contact 7.

L'ensemble 6 est enrobé dans une résine 21, puis pris en sandwich entre différentes couches (22a, 22b, 23a, 23b) disposées de part et d'autre de l'ensemble 6. Une couche de résine 21 est alors possiblement présente de part et d'autre de l'ensemble 6.

Dans un exemple de mise en œuvre, ce tout est ensuite laminé, à chaud ou à froid, de sorte à former un corps 10 de carte électronique. Le corps 10 est ainsi réalisé par assemblage de différentes couches superposées, et l'ensemble 6 est noyé dans le corps 10.

La résine 21 est par exemple du polyuréthane (PU).

Chacune des couches (22a, 22b, 23a, 23b) est par exemple en PVC ou PET ou polycarbonate. Les couches (22a, 22b, 23a, 23b) peuvent être constituées d'un même matériau ou de différents matériaux selon la carte à réaliser, et de même, les matériaux utilisés pour les couches peuvent varier de l'une à l'autre.

Dans un exemple de réalisation, le corps 10 comporte par exemple successivement une couche supérieure 23a, couramment appelée « overlay » supérieur, par exemple ici en PVC, une couche imprimée supérieure 22a, par exemple ici en PVC, puis la couche de résine 21 dans laquelle est noyée l'ensemble 6, puis une couche imprimée inférieure 22b, par exemple ici en PVC, et enfin une couche inférieure 23b, couramment appelée « overlay » inférieur, par exemple ici en PVC.

Le corps 10 de la carte électronique 20 comporte en outre la cavité 11 ayant un fond 12.

Comme l'illustre la figure 4, bien que l'ensemble 6 soit considéré comme noyé dans la résine 21, une surface de contact 5 de la bosse de connexion 4 est tangente au fond 12 de la cavité 11.

La cavité est par exemple formée par usinage du corps 10 à partir d'une surface supérieure du corps (ici par exemple de la couche overlay supérieur 23a), jusqu'à usiner une partie de la hauteur des bosses de connexion 4 pour former les surfaces de contact 5.

En outre, le corps de carte 10 comporte une sous-cavité 13, creusée, par exemple par usinage, dans le fond 12 de la cavité 11.

La sous-cavité 13 est par exemple conforme à l'une des représentations des figures 2 ou 3.

Une fois la cavité 11 avec une sous-cavité 13 formées, comme l'illustre la figure 4, le module 30 est encarté dans la cavité 11.

Dans le présent exemple de réalisation, le module 30 comporte un capteur formant sa face extérieure 31, comme un capteur biométrique, par exemple un capteur d'empreinte. Selon d'autres exemples, le module 30 pourrait comporter un afficheur, ou le capteur pourrait être un autre type de capteur biométrique, ou il pourrait s'agir d'un module à contacts tel que défini par la norme ISO 7816.

Afin d'être connecté électriquement à la surface de contact 5, le module 30 comporte en outre par exemple une plage de contact électrique sur une face intérieure 32.

Afin de réaliser la connexion électrique avec la surface de contact 5, une couche d'adhésif électriquement conducteur 33, par exemple ici un adhésif anisotrope (souvent désigné « ACF » pour « anisotropic conductive film »), est appliquée sur la face intérieure 32 du module 30.

Ainsi, l'adhésif électriquement conducteur 33 recouvre au moins la plage de contact électrique de la face inférieure 32 du module 30.

L'adhésif électriquement conducteur 33 pourrait aussi être une colle conductrice ou une pâte à braser déposée localement sur les surfaces de contact 5 pour réaliser la connexion électrique entre le module 30 et les surfaces de contact 5.

La pâte à braser désigne ici une pâte à basse température de fusion (i.e. environ 100°C). Il s'agit par exemple d'un alliage à base d'étain. Cet alliage redevient visqueux lorsque le module est encarté dans la cavité.

La colle conductrice et la pâte à braser sont des conducteurs électriques dans toutes les directions.

Une fois le module 30 en place dans la cavité 11, une pression est appliquée sur le module, éventuellement à chaud.

La pression est possiblement appliquée soit en périphérie de la face extérieure 31 du module soit sur l'ensemble de la face extérieure 31.

Cependant, l'application de la pression induit généralement un écoulement de l'adhésif.

Ainsi, ici, comme l'illustre la figure 5, une fois le module 30 encarté dans la cavité 11, l'adhésif électriquement conducteur 33 peut se déverser en partie dans la sous-cavité 13.

La sous-cavité 13 est ainsi configurée pour recevoir de l'adhésif lors de l'encartage d'un module, et éventuellement servir de réservoir d'adhésif.

## Revendications

1. Carte électronique (20) comportant :
- un corps de carte (10), comportant au moins un ensemble (6) comportant au moins un support (2) flexible et un circuit électronique (3) imprimé sur le support (2) flexible, dit FPC (1), le FPC (1) comportant au moins une plaque de contact (7) en surface du support (2), et au moins une bosse de connexion (4) fixée sur la plaque de contact (7) du FPC (1), l'ensemble (6) comportant en outre au moins une puce, connectée au circuit électronique (3) du FPC (1), à distance de la plaque de contact (7), et l'ensemble (6) étant noyé dans une résine (21) ;
- une cavité (11) formée dans le corps de carte (10), la cavité (11) ayant un fond (12) dans lequel apparait une surface de contact (5) de la bosse de connexion (4) ;
- un module (30), encarté dans la cavité (11), comportant une face intérieure (32) comportant au moins une plage de contact électrique ;
la carte électronique (20) étant **caractérisée en ce qu'**une couche d'adhésif électriquement conducteur (33) recouvre la face intérieure (32) comportant l'au moins une plage de contact électrique du module (30) pour connecter électriquement la plage de contact électrique du module (30) à la surface de contact (5) de la bosse de connexion (4) située au fond (12) de la cavité (11) et **en ce que** la carte électronique (20) comporte en outre une sous-cavité (13), formée dans le fond (12) de la cavité (11), à distance d'une périphérie de la cavité (11), et remplie au moins en partie par de l'adhésif électriquement conducteur (33), la surface de contact (5) de la bosse de connexion (4) étant au moins en partie en dehors de la sous-cavité (13).

2. Carte électronique (20) selon la revendication 1, **caractérisée en ce que** la sous-cavité (13) présente une profondeur d'au moins 20 µm, par exemple de 50 µm +/- 15 µm, par rapport au fond (12) de la cavité (11).

3. Carte électronique (20) selon l'une quelconque des revendications 1 ou 2, **caractérisée en ce que** la sous-cavité (13) est centrée par rapport à la cavité (11).

4. Carte électronique (20) selon l'une quelconque des revendications 1 à 3, **caractérisée en ce que** la sous-cavité (13) est configurée pour entourer au moins la bosse de connexion (4).

5. Carte électronique (20) selon l'une quelconque des revendications 1 à 4, **caractérisée en ce que** la sous-cavité (13) a une forme d'anneau et/ou comporte au moins une alvéole.

6. Carte électronique (20) selon l'une quelconque des revendications 1 à 5, **caractérisée en ce qu'**une surface apparente de la sous-cavité (13) représente entre 20% et 50% d'une surface apparente de la cavité (11), voire entre 20% et 35%.

7. Carte électronique (20) selon l'une quelconque des revendications 1 à 6, **caractérisée en ce que** la couche d'adhésif électriquement conducteur (33) présente une épaisseur comprise entre 150 µm et 250 µm entre la face intérieure (32) du module (30) et le fond (12) de la cavité (11).

8. Procédé de réalisation d'une carte électronique (20) selon l'une quelconque des revendications précédentes, comportant les étapes suivantes :
- Réalisation d'un corps de carte (10) comportant un FPC (1) et une puce connectée à un circuit électronique (3) imprimé du FPC (1) et disposée à distance d'une plaque de contact (7) du FPC (1) sur laquelle est fixée une bosse de connexion (4), le FPC (1) la puce et la bosse de connexion (4) étant noyé dans une résine (21) ;
- Formation d'une cavité (11) de profondeur constante comportant une étape d'usinage de la bosse de connexion (4) formant une surface de contact (5) de la bosse de connexion (4) ;
- Formation d'une sous-cavité (13), au fond (12) de la cavité (11), à distance d'une périphérie de la cavité (11), la surface de contact (5) de la bosse de connexion (4) étant au moins en partie en dehors de la sous-cavité (13) ;
- Fourniture d'un module (30) présentant une face intérieure (32) comportant au moins une plage de contact électrique ;
- Application d'un adhésif électriquement conducteur (33) sur la face intérieure (32) comportant l'au moins une plage de contact électrique du module (30) ;
- Mise en place du module (30) dans la cavité (11) ; et
- Application d'une pression sur au moins une partie d'une face extérieure (31) du module (30) avec un presseur.

9. Procédé selon la revendication 8 dans lequel la pression est appliquée sur une périphérie de la face extérieure (31) du module (30).

10. Procédé selon la revendication 8 dans lequel la pression appliquée sur le module (30) est homogène sur la face extérieure (31) du module (30) et est appliquée avec un presseur plein.

## Patentansprüche

1. Elektronische Karte (20), aufweisend:
- einen Kartenkörper (10), der mindestens eine Anordnung (6) aufweist, die mindestens einen flexiblen Träger (2) und einen auf den flexiblen Träger (2) gedruckten elektronischen Schaltkreis (3) aufweist, bezeichnet als FPC (1), wobei der FPC (1) mindestens eine Kontaktplatte (7) an der Oberfläche des Trägers (2) aufweist, und mindestens eine auf der Kontaktplatte (7) des FPC (1) befestigte Verbindungserhebung (4), wobei die Anordnung (6) ferner mindestens einen mit dem elektronischen Schaltkreis (3) des FPC (1) verbundenen Chip beabstandet von der Kontaktplatte (7) aufweist, und wobei die Anordnung (6) in ein Harz (21) eingelassen ist;
- eine im Kartenkörper (10) ausgebildete Aussparung (11), wobei die Aussparung (11) einen Boden (12) hat, in dem eine Kontaktoberfläche (5) der Verbindungserhebung (4) erscheint;
- ein in die Aussparung (11) eingesetztes Modul (30), das eine innere Fläche (32) aufweist, die mindestens einen elektrischen Kontaktbereich aufweist;
wobei die elektronische Karte (20) **dadurch gekennzeichnet ist, dass** eine elektrisch leitende Haftschicht (33) die innere Fläche (32) bedeckt, die den mindestens einen elektrischen Kontaktbereich des Moduls (30) aufweist, um den elektrischen Kontaktbereich des Moduls (30) mit der Kontaktoberfläche (5) der sich am Boden (12) der Aussparung (11) befindenden Verbindungserhebung (4) zu verbinden, und dass die elektronische Karte (20) ferner eine Unter-Aussparung (13) aufweist, die im Boden (12) der Aussparung (11) beabstandet von einer Peripherie der Aussparung (11) ausgebildet und mindestens zum Teil mit elektrisch leitendem Kleber (33) gefüllt ist, wobei die Kontaktoberfläche (5) der Verbindungserhebung (4) mindestens zum Teil außerhalb der Unter-Aussparung (13) ist.

2. Elektronische Karte (20) nach Anspruch 1, **dadurch gekennzeichnet, dass** die Unter-Aussparung (13) eine tiefe von mindestens 20 µm, beispielsweise von 50 µm +/- 15 µm, im Verhältnis zum Boden (12) der Aussparung (11) aufweist.

3. Elektronische Karte (20) nach einem der Ansprüche 1 oder 2, **dadurch gekennzeichnet, dass** die Unter-Aussparung (13) im Verhältnis zu der Aussparung (11) zentriert ist.

4. Elektronische Karte (20) nach einem der Ansprüche 1 bis 3, **dadurch gekennzeichnet, dass** die Unter-Aussparung (13) ausgelegt ist, um mindestens die Verbindungserhebung (4) zu umgeben.

5. Elektronische Karte (20) nach einem der Ansprüche 1 bis 4, **dadurch gekennzeichnet, dass** die Unter-Aussparung (13) eine Ringform hat und/oder mindestens eine Wabe aufweist.

6. Elektronische Karte (20) nach einem der Ansprüche 1 bis 5, **dadurch gekennzeichnet, dass** eine sichtbare Oberfläche der Unter-Aussparung (13) zwischen 20% und 50% einer sichtbaren Oberfläche der Aussparung (11) darstellt, ja sogar zwischen 20% und 35%.

7. Elektronische Karte (20) nach einem der Ansprüche 1 bis 6, **dadurch gekennzeichnet, dass** die elektrisch leitende Haftschicht (33) eine Dicke aufweist, die zwischen 150 µm und 250 µm zwischen der inneren Fläche (32) des Moduls (30) und dem Boden (12) der Aussparung (11) liegt.

8. Verfahren zur Herstellung einer elektronischen Karte (20) nach einem der vorangehenden Ansprüche, das die folgenden Schritte aufweist:
- Herstellen eines Kartenkörpers (10), der einen FPC (1) und einen Chip aufweist, der mit einem gedruckten elektronischen Schaltkreis (3) des FPC (1) verbunden und beabstandet von einer Kontaktplatte (7) des FPC (1) angeordnet ist, auf der eine Verbindungserhebung (4) befestigt ist, wobei der FPC (1), der Chip und die Verbindungserhebung (4) in ein Harz (21) eingelassen sind;
- Bilden einer Aussparung (11) konstanter Tiefe, aufweisend einen Schritt der Fertigung der Verbindungserhebung (4), die eine Kontaktoberfläche (5) der Verbindungserhebung (4) bildet;
- Bilden einer Unter-Aussparung (13) am Boden (12) der Aussparung (11) beabstandet von einer Peripherie der Aussparung (11), wobei die Kontaktoberfläche (5) der Verbindungserhebung (4) mindestens zum Teil außerhalb der Unter-Aussparung (13) ist;
- Bereitstellen eines Moduls (30), das eine innere Fläche (32) aufweist, die mindestens einen elektrischen Kontaktbereich aufweist;
- Auftragen eines elektrisch leitenden Klebers (33) auf die innere Fläche (32), die den mindestens einen elektrischen Kontaktbereich des Moduls (30) aufweist;
- Platzieren des Moduls (30) in die Aussparung (11); und
- Anwenden eines Drucks auf mindestens einen Teil einer äußeren Fläche (31) des Moduls (30) mit einer Presse.

9. Verfahren nach Anspruch 8, wobei der Druck auf eine Peripherie der äußeren Fläche (31) des Moduls (30) angewendet wird.

10. Verfahren nach Anspruch 8, wobei der auf das Modul (30) angewendete Druck auf der äußeren Fläche (31) des Moduls (30) gleichmäßig ist und mit einer Vollpresse angewendet wird.

## Claims

1. An electronic board (20) including:
- a board body (10), including at least one assembly (6) including at least one flexible medium (2) and one electronic circuit (3) printed on the flexible medium (2), called FPC (1), the FPC (1) including at least one contact plate (7) on the surface of the medium (2), and at least one connection bump (4) fixed on the contact plate (7) of the FPC (1), the assembly (6) further including at least one chip, connected to the electronic circuit (3) of the FPC (1), at a distance from the contact plate (7), and the assembly (6) being embedded into a resin (21);
- a cavity (11) formed in the board body (10), the cavity (11) having a bottom (12) in which a contact surface (5) of the connection bump (4) appears;
- a module (30), inserted into the cavity (11), including an inner face (32) including at least one electrical contact pad;
the electronic board (20) being **characterized in that** a layer of electrically conductive adhesive (33) covers the inner face (32) including the at least one electrical contact pad of the module (30) for electrically connecting the electrical contact pad of the module (30) to the contact surface (5) of the connection bump (4) located at the bottom (12) of the cavity (11) and **in that** the electronic board (20) further includes a sub-cavity (13), formed in the bottom (12) of the cavity (11), at a distance from a periphery of the cavity (11), and filled at least partly with the electrically conductive adhesive (33), the contact surface (5) of the connection bump (4) being at least partly outside the sub-cavity (13)

2. The electronic board (20) according to claim 1, **characterized in that** the sub-cavity (13) has a depth of at least 20 µm, for example 50 µm +/- 15 µm, relative to the bottom (12) of the cavity (11).

3. The electronic board (20) according to any one of claims 1 or 2, **characterized in that** the sub-cavity (13) is centered relative to the cavity (11).

4. The electronic board (20) according to any one of claims 1 to 3, **characterized in that** the sub-cavity (13) is configured to surround at least the connection bump (4).

5. The electronic board (20) according to any one of claims 1 to 4, **characterized in that** the sub-cavity (13) has the shape of a ring and/or includes at least one cell.

6. The electronic board (20) according to any one of claims 1 to 5, **characterized in that** an apparent surface of the sub-cavity (13) represents between 20% and 50% of an apparent surface of the cavity (11), even between 20% and 35%.

7. The electronic board (20) according to any one of claims 1 to 6, **characterized in that** the electrically conductive adhesive layer (33) has a thickness between 150 µm and 250 µm between the inner face (32) of the module (30) and the bottom (12) of the cavity (11).

8. A method for making an electronic board (20) according to any one of the preceding claims, including the following steps:
- Making a board body (10) including an FPC (1) and a chip connected to a printed electronic circuit (3) of the FPC (1) and disposed at a distance from a contact plate (7) of the FPC (1) on which a connection bump (4) is fixed, the FPC (1), the chip and the connection bump (4) being embedded into a resin (21);
- Forming a cavity (11) of constant depth including a step of machining the connection bump (4) forming a contact surface (5) of the connection bump (4);
- Forming a sub-cavity (13), at the bottom (12) of the cavity (11), at a distance from a periphery of the cavity (11), the contact surface (5) of the connection bump (4) being at least partly outside the sub-cavity (13);
- Providing a module (30) having an inner face (32) including at least one electrical contact pad;
- Applying an electrically conductive adhesive (33) on the inner face (32) including the at least one electrical contact pad of the module (30);
- Placing the module (30) in the cavity (11); and
- Applying a pressure on at least part of an outer face (31) of the module (30) with a presser.

9. The method according to claim 8 wherein the pressure is applied on a periphery of the outer face (31) of the module (30).

10. The method according to claim 8 wherein the pressure applied on the module (30) is homogeneous on the outer face (31) of the module (30) and is applied with a full presser.
